Europäisches Patentamt

European Patent Office

Office européen des brevets

(11) Publication number: 0 302 647
A1

## EUROPEAN PATENT APPLICATION

(21) Application number: 88306847.0

(22) Date of filing: 26.07.88

(51) Int. Cl.⁴: H01L 21/60

(30) Priority: 03.08.87 US 81082

(43) Date of publication of application:
08.02.89 Bulletin 89/06

(84) Designated Contracting States:
DE FR GB IT NL

(71) Applicant: AMERICAN TELEPHONE AND
TELEGRAPH COMPANY
550 Madison Avenue
New York, NY 10022(US)

(72) Inventor: Lee, Kuo-Hua
1308 Country Club Road
Wescosville Pennsylvania 18106(US)
Inventor: Lu, Chih-Yuan
5371 Andrea Drive
Wescosville Pennsylvania 18106(US)

(74) Representative: Johnston, Kenneth Graham et
al
AT&T (UK) LTD. AT&T Intellectual Property
Division 5 Mornington Road
Woodford Green Essex, IG8 OTU(GB)

(54) Aluminum plug using insulating sidewall space.

(57) A method of forming aluminum contacts 7 using insulating sidewall spacers 5 at the edges of windows in a dielectric layer 3 is described. The contacts are fabricated by forming insulating sidewall spacers in the windows, depositing a metal layer and etching to form a planar surface which may expose the underlying dielectric layer.

FIG. 5

## Aluminum Plug Using Insulating Sidewall Space

### Technical Field

This invention relates to semiconductor integrated circuits and to the metallizations used in such integrated circuits.

### Background of the Invention

As integrated circuits grow more complex, the problems involved in making electrical contacts to individual devices within the circuits become more difficult. The problems become more difficult because, for example, windows in dielectric layers which expose selected portions of the underlying material are used for the electrical contacts to individual devices or contacts between different levels of metal and they become smaller as the circuits become more complex. As might be expected, windows become more difficult to fill as they become smaller. Headless contacts to further reduce the area required for electrical connections are frequently desired but typically are not as easily fabricated as are other contacts.

Aluminum is presently the most commonly used material for integrated circuit electrical connections. However, for windows less than approximately 1 $\mu$m in diameter, the use of aluminum has not been completely successful. Problems in filling the windows arise because aluminum does not deposit conformally, and thinning of the metal at the edges of the windows may occur. Reentrant angles may also be formed. Both are undesirable.

An approach to solving these problems is disclosed in U.S. Patent No.4,507,853 issued on April 2, 1985. This patent discloses a two-step metallization process in which an aluminum layer is first deposited on a dielectric surface which includes windows. The aluminum layer is then anisotropically etched to expose the dielectric layer. At this point, etching is terminated and portions of the substrate within the windows are exposed with aluminum spacers at the edges of the windows. A second metal layer is then deposited and it is stated that the metal thickness at the edges, i.e., step coverage, of the windows is increased.

The process disclosed, however, does not directly address the problem of nonconformal aluminum deposition and thus does not appear to be very advantageously practiced with small windows as reentrant angles are likely to occur with the first metal deposition. Additionally, the final metallization has a decidedly nonplanar surface which is clearly undesirable for many purposes. However, there is yet another, and more fundamental, problem with the disclosed process. Deposition of metal layer 23 for sidewall segments 13, if uniform on the entire surface as described, yields metal spacers along all of the topographic structural edges including, e.g., gate edge, gate runner edges and any isolated lower level metal runner edges. These undesired metal spacers or stringers may cause electrical shorts between devices.

### Summary of the Invention

Integrated circuits having electrical contacts through windows, i.e., plugs, are expediently fabricated by patterning a dielectric layer on a substrate to form windows which expose selected portions of the underlying substrate, forming dielectric sidewall spacers in said windows, depositing a layer of metal on said dielectric and said exposed substrate, and selectively removing said metal thereby yielding a substantially planar surface. In a preferred embodiment, the metal is aluminum. The aluminum may be selectively removed to form an essentially planar surface, or it may be selectively removed to form a planar surface after which a second level metal runner is formed by patterning.

### Brief Description of the Drawing

FIGs. 1-4 are useful in explaining formation of contacts according to this invention;

FIGs. 5-6 illustrate electrical contacts according to this invention; and

FIGs. 7-9 are useful in explaining another embodiment of this invention.

### Detailed Description

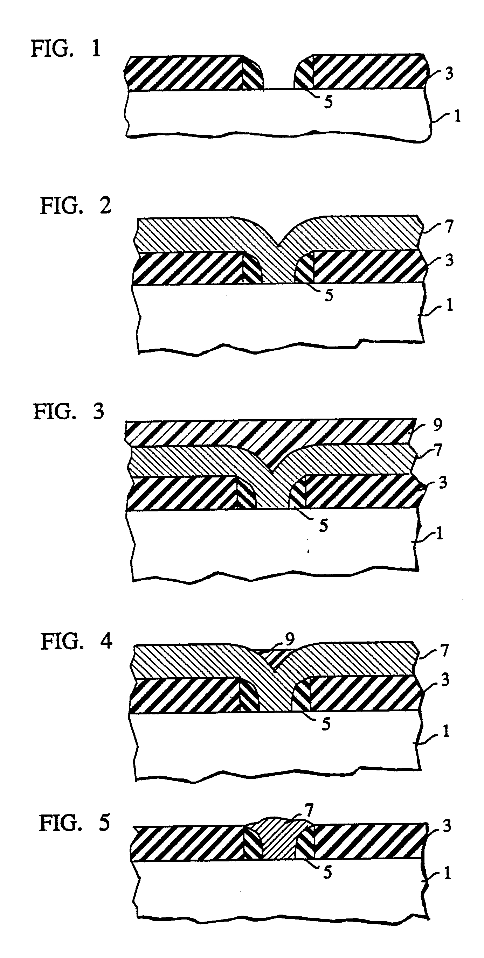

FIG. 1 depicts a substrate 1, patterned dielectric layer 3 and sidewall spacers 5. The sidewall spacers 5 are formed at the edges of an opening in patterned dielectric layer 3 which exposes selected portions of substrate 1. The openings are conveniently termed windows and typically have diameters less than approximately 1.0 $\mu$m. The term "substrate" is used in a broad sense and may comprise silicon or the first level metallization or any other lower level metal interconnection which may be present. The term is thus used to mean the material underlying the dielectric layer 3. The dielectric is typically an oxide although other insulators may be used. A typical dielectric thickness is approximately 60 nm, but the thickness is not critical for this invention. It will be readily appreciated that devices are present and that there will be many more windows present.

Patterning of the dielectric layer to form windows, as well as its formation, is by techniques well known to those skilled in the art. The sidewall spacers typically comprise an oxide formed by a technique such as that described by K. H. Lee in U.S. Patent 4,641,420 issued on February 10, 1987. Any dielectric that can be formed conformally can be used for the sidewall spacers.

After patterning the dielectric layer and forming the sidewall spacers, an aluminum layer 7 is deposited to form the structure depicted in FIG. 2. In the embodiment depicted, the deposited aluminum layer 7 has a thickness approximately equal to that of the dielectric layer. However, layers may be used having a thickness greater than that of the dielectric layer. It should be noted that the aluminum layer is deposited without any reentrant angles, due to the sidewall spacers, and that the layer has a non-planar surface due to the window. There is a valley in the aluminum layer over the window.

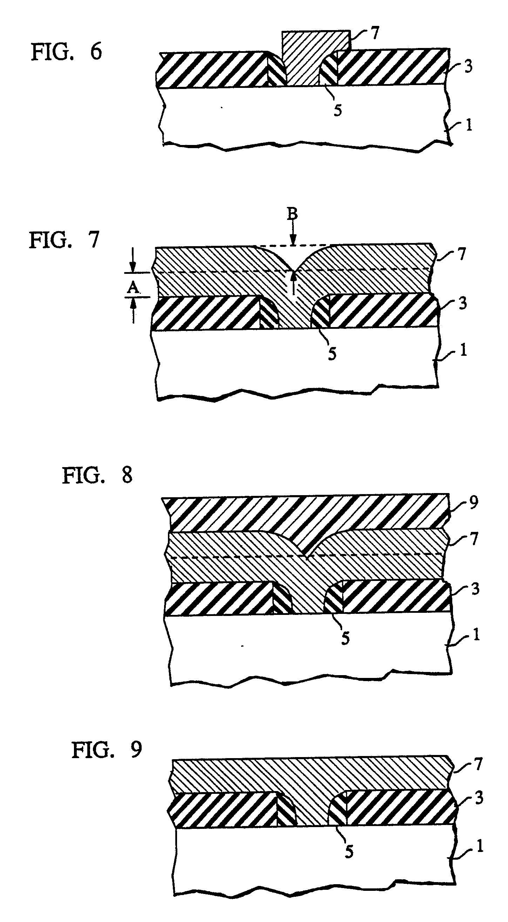

A layer of photoresist 9 is now deposited and spin coated to yield the essentially planar surface depicted in FIG. 3. The photoresist may be any conventional and well known photoresist. At this point, etching of the photoresist commences, using a first etchant, and continues until a portion of the surface of aluminum layer 7 is reached and exposed. It will be appreciated that no mask is used and there are thus no registration problems. This structure is depicted in FIG. 4.

At this point, the etching conditions are changed and a second etchant is selected which etches only aluminum. Thus, the remaining photoresist 9 in the Al valley over the window acts as an etching mask and protects the central portion of the aluminum layer on top of the window. It should be noted that the etching mask is therefore self-aligned with respect to the window opening. The etching continues until the dielectric surface is exposed, the remaining photoresist is stripped. The resulting contact is depicted in FIG. 5. It should be noted that the contact has an essentially planar surface because some of the aluminum layer underneath the photomask is removed. This is expected from an etching process that is not completely anisotropic in the vertical direction but has some undercutting. Only a single contact is depicted, although it will be readily appreciated, as previously mentioned, that an integrated circuit will have many such contacts.

Variations of the process described are contemplated. One such variation yields the structure in FIG. 6 which depicts a second level metal runner. Fabrication of this structure is more easily understood by reference to FIGs. 7-9. The aluminum deposition continues until the distance, A, from the top of the dielectric layer 3 to the bottom of the aluminum valley is approximately equal to or greater than the desired thickness of the second level metal runner. The valley has a depth, B. The structure is depicted in FIG. 7. Photoresist is now applied and spin coated to yield a planar surface as depicted in FIG. 8. The photoresist and aluminum are now etched, as previously described, until the bottom of the valley is reached. Alternatively, a single step etch using chemistry which etches photoresist and the metal at the same rate can be used. At this point, etching is stopped and an essentially planar surface has been obtained as depicted in FIG. 9. Standard lithographic techniques are now used to pattern the aluminum layer to yield the structure depicted in FIG. 6.

## Claims

1. A method of making a semiconductor integrated circuit comprising the step of
forming a dielectric layer on a substrate;
patterning said dielectric layer to form at least one window which exposes at least a selected portion of said substrate; and
fabricating an electrical contact through said at least one window to said substrate
**CHARACTERIZED IN THAT**
said fabricating comprises the steps of
forming dielectric sidewall spacers in said windows;
depositing a metal over said dielectric layer and in said windows; and
selectively removing said metal to yield a substantially planar surface.

2. A method as recited in claim 1 further
**CHARACTERIZED IN THAT**
said selectively removing step comprises:
depositing a layer of photoresist and etching said photoresist until said metal layer is exposed.

3. A method as recited in claim 2 further
**CHARACTERIZED IN THAT**
etching is continued until a portion of said dielectric layer is exposed.

4. A method as recited in claim 2 further
**CHARACTERIZED IN THAT**
metal layer has a valley over said at least one window and the thickness of said layer between said valley and said dielectric is at least equal to the thickness of the metal runner.

5. A method as recited in claim 4 further
**CHARACTERIZED IN THAT**
said method comprises the further step of patterning said metal layer thereby forming metal runners.

FIG. 1

FIG. 2

FIG. 3

FIG. 4

FIG. 5

FIG. 6

FIG. 7

FIG. 8

FIG. 9

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y,D | US-A-4 641 420 (LEE)<br>* Claim 1 *<br>--- | 1 | H 01 L 21/60 |
| Y | US-A-4 614 563 (KUBO)<br>* Claim 1 * | 1 | |
| A | | 2,3 | |
| A | US-A-4 489 481 (JONES)<br>----- | | |

TECHNICAL FIELDS
SEARCHED (Int. Cl.4)

H 01 L

The present search report has been drawn up for all claims

| Place of search | Date of completion of the search | Examiner |
|---|---|---|
| THE HAGUE | 09-11-1988 | PHEASANT N.J. |

EPO FORM 1503 03.82 (P0401)